# EUROPÄISCHE PATENTANMELDUNG

(11) **EP 4 386 819 A1**
(43) Veröffentlichungstag der Anmeldung: **19.06.2024**
(21) Anmeldenummer: 22213702.8
(22) Anmeldetag: 15.12.2022
(51) Int. Cl.: H01L 21/66, H01L 21/673, C30B 29/00, C30B 33/00

(54) **VERFAHREN ZUM TESTEN DER WIDERSTANDSFÄHIGKEIT VON HALBLEITERSCHEIBEN AUS EINKRISTALLINEM SILIZIUM GEGEN THERMISCH INDUZIERTE VERSETZUNGEN**

(71) Anmelder: Siltronic AG, 81677 München (DE)
(72) Erfinder: Boy, Michael, 83329 Waging am See (DE); Soyka, Elena, 84547 Emmerting (DE); Köster, Ludwig, 84489 Burghausen (DE)
(74) Vertreter: Staudacher, Wolfgang

(57) **Zusammenfassung**

Verfahren zum Testen der Widerstandsfähigkeit von Halbleiterscheiben aus einkristallinem Silizium gegen thermisch induzierte Versetzungen, umfassend
das Unterziehen einer Halbleiterscheibe einer auf Eigenschaften des Halbleitermaterials abgestimmten Wärmebehandlung in einem Vertikalofen, wobei die Halbleiterscheibe einen Durchmesser aufweist und an Auflagestellen einer Anzahl von Fingern eines Boots aufliegt und ein Abstand der Auflagestellen zu einem Rand der Halbleiterscheibe eine Länge hat, die nicht weniger als 5 % und nicht mehr als 40 % des Durchmessers der Halbleiterscheibe beträgt;
das Durchführen einer BFA-Analyse von einer oder mehreren Teilflächen der Halbleiterscheibe um die Auflagestellen mittels eines SIRD-Systems, wobei der kürzeste Abstand der einen oder mehreren Teilflächen zum Rand der Halbleiterscheibe nicht weniger als 1 mm und nicht mehr als 33 % des Durchmessers der Halbleiterscheibe beträgt.

## Beschreibung

Gegenstand der Erfindung ist ein Verfahren zum Testen der Widerstandsfähigkeit von Halbleiterscheiben aus einkristallinem Silizium gegen thermisch induzierte Versetzungen. Thermisch induzierte Versetzungen führen zu plastischer Verformung der Halbleiterscheibe und haben einen negativen Einfluss auf die Ausbeute von Halbleiterbauelementen.

### Stand der Technik / Probleme

Seitens der Hersteller von elektronischen Bauelementen besteht ein Bedürfnis nach in Hochtemperaturprozessen mechanisch robusten Halbleiterscheiben und daher, vom Lieferanten von Halbleiterscheiben verlässliche Informationen bezüglich deren Robustheit gegen thermischen Stress zu erhalten.

In US2010 0 015 817 A1 ist beschrieben, dass Wärmebehandlungen von Halbleiterscheiben in einem Vertikalofen thermisch induzierte Versetzungen verursachen können, deren Ursprung sich an Auflagestellen von Fingern eines Boots befindet, auf denen die Halbleiterscheiben während der Wärmebehandlung aufliegen.

US 2002 0 119 641 A1 beschreibt eine Hochtemperatur-Wärmebehandlung für Substrate aus Silizium, im Verlauf derer ein Boot mit Fingern aus Polysilizium zum Einsatz kommt.

US2004 0 021 097 A1 beschreibt eine Möglichkeit, wie SIRD (Scanning Infrared Depolarization) eingesetzt werden kann, um mechanische Spannungen von Halbleiterscheiben zu untersuchen.

In JP2015-73049 A wird gezeigt, dass thermisch induzierte Versetzungen mittels SIRD und einer BFA-Analyse (Bad-Fraction-Area) quantitativ beschrieben werden können.

Gemäß JP2006 269 896 A beeinflussen die Dauer und die Temperatur der Wärmebehandlung das Auftreten von thermisch induzierten Versetzungen.

US2016 0 247 694 A1 beschreibt eine Methode zum Auswerten der Qualität von Halbleiterscheiben aus Silizium hinsichtlich deren Robustheit gegen thermisch induzierte Versetzungen. Unter anderem wurde gefunden, dass ein kritischer Stress umso größer ist, je höher die Konzentration an interstitiellem Sauerstoff ist und je niedriger die Temperatur der Wärmebehandlung ist, der getestete Halbleiterscheiben unterzogen werden, um Versetzungen zu induzieren.

Aufgabe der vorliegenden Erfindung ist es, ein Verfahren bereitzustellen, das auf einfache Weise verlässlich und reproduzierbar die Widerstandsfähigkeit von Halbleiterscheiben aus Silizium gegen thermisch induzierte Versetzungen zu beurteilen erlaubt.

Die Aufgabe der Erfindung wird gelöst durch ein Verfahren zum Testen der Widerstandsfähigkeit von Halbleiterscheiben aus einkristallinem Silizium gegen thermisch induzierte Versetzungen, umfassend
das Unterziehen einer Halbleiterscheibe einer auf Eigenschaften des Halbleitermaterials abgestimmten Wärmebehandlung in einem Vertikalofen, wobei die Halbleiterscheibe einen Durchmesser aufweist und an Auflagestellen einer Anzahl von Fingern eines Boots aufliegt und ein Abstand der Auflagestellen zu einem Rand der Halbleiterscheibe eine Länge hat, die nicht weniger als 5 % und nicht mehr als 40 % des Durchmessers der Halbleiterscheibe beträgt;
das Durchführen einer BFA-Analyse von einer oder mehreren Teilflächen der Halbleiterscheibe um die Auflagestellen mittels eines SIRD-Systems, wobei der kürzeste Abstand der einen oder mehreren Teilflächen zum Rand der Halbleiterscheibe nicht weniger als 1 mm und nicht mehr als 33 % des Durchmessers der Halbleiterscheibe beträgt.

Die Erfinder haben herausgefunden, dass sich ein einfach durchzuführender und reproduzierbarer Test gestalten lässt, wenn die Wärmebehandlung auf das zu testende Halbleitermaterial abgestimmt in einem Vertikalofen vorgenommen wird und die zu testende Halbleiterscheibe dabei auf Fingern eines Boots (long finger boat) aufliegt, und der Abstand der Auflagestellen zum Rand der Halbleiterscheibe vergleichsweise groß ist. Damit wird der Weg für thermisch induzierte Versetzungen, um bis zum Rand der Halbleiterscheibe zu gelangen, vergrößert und vermieden, dass Randeffekte das Testergebnis beeinflussen. Der Ort der Auflagestellen, an denen die zu testende Halbleiterscheibe und die Finger des Boots in Kontakt kommen, ist für alle zu testenden Halbleiterscheiben vergleichbar. Die Anzahl der Finger und damit diejenige der Auflagestellen beträgt mindestens drei, vorzugsweise drei oder vier.

Eine zu testende Halbleiterscheibe besteht aus einkristallinem Silizium und hat vorzugsweise einen Durchmesser von mindestens 200 mm. Getestet werden kann beispielsweise eine Substratscheibe aus einkristallinem Silizium mit polierten Seitenflächen oder eine solche Substratscheibe, die zusätzlich eine auf der oberen Seitenfläche abgeschiedene epitaktische Schicht aufweist oder eine SOI-Scheibe (silicon on insulator).

Hinsichtlich der Eigenschaften des Halbleitermaterials, die für die Gestaltung der Wärmebehandlung von Bedeutung sind, kommen grundsätzlich alle Parameter in Frage, die Einfluss auf die mechanische Stabilität des Halbleitermaterials bei thermischer Beanspruchung haben. Für Halbleiterscheiben aus Silizium sind das beispielsweise die Konzentration an interstitiellem Sauerstoff (Oᵢ) und die elektrische Resistivität, die von der Konzentration elektrisch aktiver Dotierstoffe abhängt.

Die Dauer und/oder die Temperatur der Wärmebehandlung werden auf die Eigenschaften des Halbleitermaterials der zu testenden Halbleiterscheibe abgestimmt. Durch die Wärmebehandlung sollen Versetzungen induziert werden, deren Ausdehnung in Form von Versetzungslinien in der Depolarisations-Karte innerhalb der Teilflächen bleibt, die mittels BFA-Analyse ausgewertet werden. Natürlich kann auch eine Halbleiterscheibe getestet werden, bei der die Eigenschaften des Halbleitermaterials nicht bekannt sind. Stellt sich heraus, dass der Test mit der ausgewählten Wärmebehandlung kein zufriedenstellendes Ergebnis liefert, muss gegebenenfalls ein Test an einer gleichartigen Halbleiterscheibe durchgeführt werden, wobei eine anders gestaltete Wärmebehandlung durchgeführt wird. Die Wärmebehandlung ist so konzipiert, dass ihre Dauer bei der Zieltemperatur ausreichend lang ist, um thermisch induzierte Versetzungen zu erzeugen, aber auch ausreichend kurz, um wirtschaftlich zu sein und um zu vermeiden, dass entstehende Versetzungen bis zum Rand der Halbleiterscheibe laufen. Die Dauer der Wärmebehandlung bei der Zieltemperatur beträgt vorzugsweise 5 bis 30 Minuten. Die Atmosphäre, in der die Wärmebehandlung durchgeführt wird, kann unabhängig von Halbleitermaterial ausgewählt werden. Geeignet sind beispielsweise Sauerstoff, Stickstoff oder ein Edelgas wie Argon oder eine Kombination der genannten Gase.

Die zu testende Halbleiterscheibe kann vor dieser Wärmebehandlung bereits einer vorausgehenden Wärmebehandlung (pre-anneal) unterzogen worden sein, beispielsweise einer Wärmebehandlung, durch die Keime von Sauerstoff-Präzipitaten zu BMDs (bulk micro defects) entwickelt werden, oder einer RTA-Behandlung (rapid thermal anneal). Wird die vorausgehende Wärmebehandlung auch auf einem Boot in einem Vertikalofen durchgeführt, sollten die Auflagestellen der Wärmebehandlungen vorzugsweise nicht überlappen. Um das zu erreichen kann die Halbleiterscheibe nach der vorausgehenden Wärmebehandlung gedreht auf dem Boot abgelegt werden. Eine vorausgehende Wärmebehandlung zur Entwicklung von BMDs umfasst vorzugsweise das Erhitzen der Halbleiterscheibe unter einer Atmosphäre von Sauerstoff für einen Zeitraum von 3 Stunden bei einer Temperatur von 780 °C und anschließend für einen Zeitraum von 16 Stunden bei einer Temperatur von 1000 °C.

Für Halbleiterscheiben aus einkristallinem Silizium, die mit Bor p-dotiert sind, wird vorgeschlagen, mindestens zwei verschieden gestaltete Wärmebehandlungen zur Auswahl zu stellen. Die eine Wärmebehandlung ist abgestimmt auf Halbleitermaterial, das vergleichsweise schwach dotiert ist (p⁻-dotiert), also einen spezifischen elektrischen Widerstand von ungefähr 1 Ohmcm oder mehr aufweist, die andere Wärmebehandlung auf Halbleitermaterial, das vergleichsweise viel Dotierstoff enthält (p⁺-dotiert), also einen spezifischen elektrischen Widerstand von 100 mOhmcm oder weniger aufweist. Durch einfache Versuche kann herausgefunden werden, ob und wie gegebenenfalls die Bedingungen der Wärmebehandlungen angepasst werden müssen, wenn zusätzliche oder andere Dotierstoffe als Bor in der Halbleiterscheibe enthalten sind. Auch die Form der Fläche des Boots an der Auflagestelle hat einen Einfluss auf die mechanische Belastung der Halbleiterscheibe, weshalb solche Versuche diesen Umstand gegebenenfalls berücksichtigen sollten. Ziel der Versuche ist es, mittels der Wärmebehandlung Versetzungen zu induzieren, deren Ausdehnung in der spezifizierten Teilfläche um die Auflagestelle bleibt und die durch Verwendung des SIRD-Systems charakterisiert werden können.

Die nachfolgende Tabelle 1 enthält die Temperatur-Etappen (ramp to) und die Geschwindigkeit der Temperaturänderung (ramp rate) zweier bevorzugter Wärmebehandlungen Rezept 1 (links) und Rezept 2 (rechts) in einer Atmosphäre von Sauerstoff und Stickstoff, die sich insbesondere durch unterschiedliche Zieltemperaturen von 1100 °C beziehungsweise 1200 °C unterscheiden. Rezept 1 eignet sich besonders zum Testen von Halbleiterscheiben aus einkristallinem Silizium mit einem Durchmesser von 300 mm, die p⁻-dotiert sind und Rezept 2 zum Testen von solchen Halbleiterscheiben, die p⁺-dotiert sind oder von epitaktisch beschichteten Halbleiterscheiben aus einkristallinem Silizium vom pp⁺-Typ. Die Wärmebehandlungen sind auf die Verwendung eines von Ferrotec Material Technologies Corporation vertriebenen Boots aus Polysilizium hin optimiert.

**Tabelle 1**

| ramp to [°C] | ramp rate [K/min] | Dauer bei Zieltemp. [min] | ramp to [°C] | ramp rate [K/min] | Dauer bei Zieltemp. [min] |
|---|---|---|---|---|---|
| 900 | 5 | | 900 | 5,0 | |
| 1000 | 5 | | 1000 | 5 | |
| 1050 | 2,9 | | 1100 | 1 | |
| 1100 | 1 | 5-30 | 1150 | 2 | |
| 1050 | 1,7 | | 1200 | 0,5 | 5-30 |
| 1000 | 2 | | 1150 | 0,7 | |
| 600 | 10 | | 1100 | 1 | |
| | | | 1050 | 1,7 | |
| | | | 1000 | 2 | |
| | | | 600 | 10 | |

Nach der Wärmebehandlung und einer dieser gegebenenfalls vorausgehenden Wärmebehandlung wird eine BFA-Analyse mittels eines SIRD-Systems durchgeführt. Das SIRD-System liefert eine Stressfeld-Abbildung in Form einer Depolarisations-Karte (full wafer map), die gegebenenfalls durch einen Hochpass-Filter geglättet die Depolarisation in Abhängigkeit der Position auf der Fläche der Halbleiterscheibe angibt. Vorzugsweise wird die höchste, vom SIRD-System angebotene Auflösung verwendet. Das erfindungsgemäße Verfahren sieht vor, die Depolarisation beschränkt auf eine oder mehrere Teilflächen um die Auflagestellen herum auszuwerten, an denen während der Wärmebehandlung Kontakt zwischen der Halbleiterscheibe und den Fingern des Boots bestand. Der Abstand der Auflagestellen zum Rand der Halbleiterscheibe hat eine Länge, die nicht weniger als 5 % und nicht mehr als 40 % des Durchmessers der Halbleiterscheibe beträgt, vorzugsweise nicht weniger als 10 % und nicht mehr als 35 % des Durchmessers der Halbleiterscheibe und besonders bevorzugt nicht weniger als 45 mm für eine Halbleiterscheibe mit einem Durchmesser von 300 mm. Der kürzeste Abstand der einen oder mehreren Teilflächen zum Rand der Halbleiterscheibe hat eine Länge, die nicht weniger als 1 mm und nicht mehr als 33 % des Durchmessers der Halbleiterscheibe beträgt, vorzugsweise nicht weniger als 3 mm und nicht mehr als 25 % des Durchmessers der Halbleiterscheibe, besonders bevorzugt nicht weniger als 10 mm für einer Halbleiterscheibe mit einem Durchmesser von 300 mm. Ein solcher Abstand zum Rand ist von Vorteil, da damit der Einfluss des Randbereichs auf die Depolarisation weitgehend ausgeschlossen wird, so dass das Messergebnis im Wesentlichen von den Eigenschaften des Halbleitermaterials selbst abhängt.

Die eine oder mehreren Teilflächen sind vorzugsweise kreisförmig, und wird mit mehreren davon gearbeitet, ist deren Radius vorzugsweise derselbe. Es kann eine kreisförmige Teilfläche verwendet werden, deren Mittelpunkt eine Auflagestelle ist oder eine, auf der zwei oder mehrere der Auflagestellen liegen. Von der Kreisform abweichende Formen sind ebenfalls möglich, beispielsweise eine oder mehrere Teilflächen mit rechteckiger oder quadratischer Form, oder mit der Form eines Dreiecks oder eines Rings.

Im Zuge der BFA-Analyse wird die Depolarisation für Zellen eines Gitters bestimmt, das virtuell über die Depolarisations-Karte gelegt ist. Das Gitter besteht vorzugsweise aus quadratischen Zellen mit einer Kantenlänge von vorzugsweise 2 mm. Überschreitet der Wert der Depolarisation in einer Zelle innerhalb einer Teilfläche einen gesetzten Schwellwert-Bereich, wird diese Zelle zur Anzahl schlechter Zellen (bad cells) hinzugefügt. Untere und obere Grenze des gesetzten Schwellwert-Bereichs sind vorzugsweise ± 10 DU bis ± 30 DU. Das Verhältnis der Anzahl schlechter Zellen zur Anzahl aller ausgewerteter Zellen ist ein Maß für die Widerstandsfähigkeit der Halbleiterscheibe gegen thermisch induzierte Versetzungen. Zellen, die nicht vollständig in einer Teilfläche liegen, werden nur mitgezählt, wenn die Fläche der betroffenen Zelle mindestens 50% beträgt. Die Auswertung kann wahlweise erfolgen, indem dieses Verhältnis für eine, mehrere oder jede der einen oder mehreren Teilflächen ermittelt wird und Teile der Ergebnisse gegebenenfalls gemittelt werden. Darüber hinaus kann zusätzlich die Verteilung schlechter Zellen innerhalb der einen oder mehreren Teilflächen statistisch ausgewertet werden, um die Ausdehnung des Stressfelds beziehungsweise dessen Gleichmäßigkeit innerhalb der einen oder mehreren Teilflächen zu beschreiben.

Die Untersuchung von hochdotierten Halbleiterscheiben aus Silizium mit einem SIRD-System ist physikalisch limitiert. Ab einem spezifischen Widerstand im Bereich von unter 6 mOhmcm beginnt die Absorption durch freie Ladungsträger die Transmission der IR-Strahlung zu blockieren.

Die Erfindung wird nachfolgend unter Bezugnahme auf Zeichnungen an Beispielen weiter beschrieben.

### Kurzbeschreibung der Figuren

**Fig. 1** zeigt eine typische Depolarisations-Karte, auf der kreisförmige Teilflächen hervorgehoben sind, für die die BFA-Analyse durchgeführt wird.
**Fig. 2** zeigt eine der Teilflächen und ein virtuell darüber gelegtes Gitter.
**Fig.3** zeigt das Ergebnis einer BFA-Analyse für verschiedene Gruppen von Halbleiterscheiben aus einkristallinem Silizium.

### Liste der verwendeten Bezugszeichen

- **1**: Halbleiterscheibe
- **2**: Teilfläche
- **3**: Auflagestelle
- **4**: Rand
- **5**: Versetzungslinie
- **6**: Gitter

### Detaillierte Beschreibung erfindungsgemäßer Ausführungsbeispiele

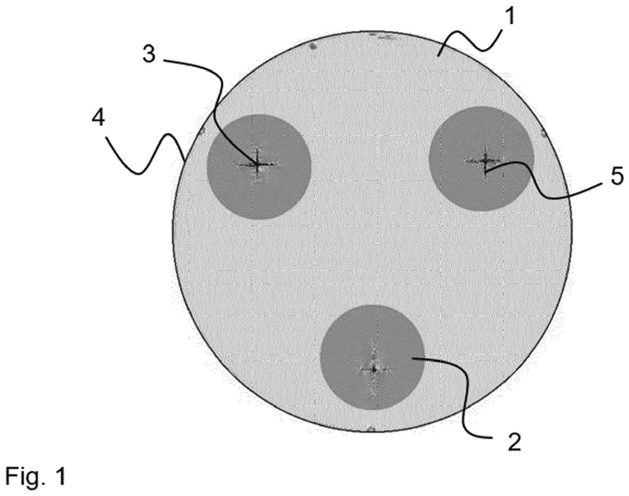

Fig.1 zeigt eine Depolarisations-Karte einer Halbleiterscheibe 1 aus einkristallinem Silizium, auf der drei kreisförmige Teilflächen 2 hervorgehoben sind, für die die BFA-Analyse durchgeführt wird. Im Zentrum der Teilflächen 2 sind die Auflagestellen 3, wo während der Wärmebehandlung Kontakt zwischen der Halbleiterscheibe 1 und den Fingern des Boots bestand. Der Abstand der Auflagestellen 3 zum Rand 4 der Halbleiterscheibe hat die geforderte Länge. Als Folge der thermischen Belastung und der gravitationsinduzierten mechanischen Spannung an und um die Auflagestellen erstrecken sich Versetzungslinien 5 entlang energetisch bevorzugter Kristallebenen in Richtung des Rands 4 der Halbleiterscheibe 1. Der Abstand zwischen dem Rand 4 der Halbleiterscheibe 1 und den Teilflächen 2 hat die geforderte Länge, so dass vom Rand 4 ausgehende, das Stressfeld beeinflussende Störungen kaum Einfluss auf die Depolarisation in den Teilflächen 2 haben. Darüber hinaus ist
die Wärmebehandlung auf die Eigenschaften des Halbleitermaterials so abgestimmt, dass sich die Versetzungslinien 5 nicht bis zum Rand 4 erstrecken, sondern die Teilflächen 2 nicht verlassen haben. Beispielsweise eine höhere Zieltemperatur und/oder eine längere Dauer der Wärmebehandlung könnten zur Folge haben, dass sich die Versetzungslinien bis zum Rand der Halbleiterscheibe erstrecken.

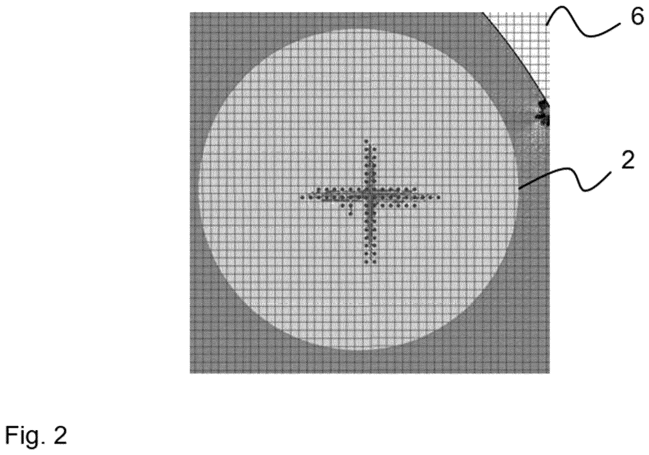

Fig.2 zeigt eine der kreisförmigen Teilflächen 2 und ein virtuell darüber gelegtes Gitter 6 für die Auswertung mittels BFA-Analyse. Diejenigen Zellen, die als schlechte Zellen gezählt werden, sind durch einen Punkt markiert.

### Beispiel

Die Widerstandsfähigkeit von Halbleiterscheiben aus einkristallinem Silizium gegen thermisch induzierte Versetzungen wurde an sechs Gruppen mit je fünf Halbleiterscheiben in drei Testläufen getestet. Alle Halbleiterscheiben hatten einen Durchmesser von 300 mm und waren mit Bor dotiert.

In Tabelle 2 sind die Materialeigenschaften der Halbleiterscheiben bezüglich Grad der Dotierung mit Bor und Konzentration an interstitiellem Sauerstoff eingetragen. Die Halbleiterscheiben der Gruppen 1-3 waren Substratscheiben mit polierten Seitenflächen, diejenigen der Gruppen 4-6 hatten auf der oberen Seitenfläche zusätzlich eine p-dotierte Schicht aus Silizium, die epitaktisch abgeschieden worden war.

| Gruppe | Dotierung | Widerstand [Ohmcm] | [Oᵢ] × 10¹⁷ cm⁻³ |
|---|---|---|---|
| 1 | p⁻ | 18,1 | 6,2 |
| 2 | p⁻ | 11,5 | 5,1 |
| 3 | p⁻ | 14700 | 1,7 |
| 4 | pp⁻ | 11,8 | 5,3 |
| 5 | pp⁺ | 0,0098 | 5,7 |
| 6 | pp⁺ | 0,025 | 4,5 |

Die Halbleiterscheiben der Gruppen 1-4 wurden einer Wärmebehandlung gemäß Rezept 1, die der Gruppen 5 und 6 einer Wärmebehandlung gemäß Rezept 2 in einem Vertikalofen von ASM International NV unterzogen, wobei jede davon auf drei Fingern eines Boots (long finger boat) des Herstellers Ferrotec Materials Technologies Corporation auflag.

Danach wurde eine BFA-Analyse mittels eines SIRD-Systems der PVA Metrology & Plasma Solutions GmbH durchgeführt und zwar auf kreisförmigen Teilflächen mit einem Radius von 40 mm um die Auflagestellen, wo während der Wärmebehandlung der Kontakt zwischen der Halbleiterscheibe und den Fingern des Boots bestand. Der kürzeste Abstand der drei Teilflächen zum Rand der Halbleiterscheibe betrug optimalerweise jeweils ca. 10 mm.

Die vom SIRD-System gelieferte hochpassgefilterte Depolarisations-Karte wurde in den Teilflächen ausgewertet und dafür ein Schwellwert-Bereich der Depolarisation von ± 10 DU (depolarization units) festgelegt. Ein Ergebnis der BFA-Analyse ist das prozentuale Verhältnis bcf (bad cell fraction) der Anzahl der schlechten Zellen in den drei Teilflächen zur Anzahl der Zellen der drei Teilflächen.

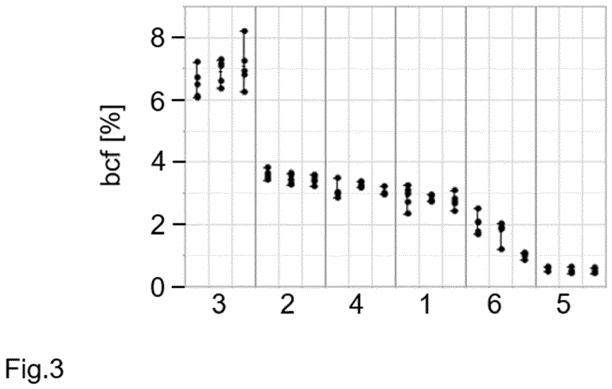

In Fig.3 ist dieses Ergebnis für die Halbleiterscheiben der Gruppen 1-6 für jeden der Testläufe dargestellt. Erwartungsgemäß steigt die Widerstandsfähigkeit gegen thermisch induzierte Versetzungen mit der Konzentration an interstitiellem Sauerstoff an und ist bei p⁺-dotierten Halbleiterscheiben ausgeprägter als bei p⁻-dotierten Halbleiterscheiben. Die Streuung der Messergebnisse der Testläufe ist gering und das Testverfahren gut reproduzierbar. Der scheinbare Ausreißer im Ergebnis der Halbleiterscheiben von Gruppe 6 erklärt sich damit, dass die entsprechenden Halbleiterscheiben von einem anderen, abweichend gezogenen Einkristall stammten.

## Patentansprüche

1. Verfahren zum Testen der Widerstandsfähigkeit von Halbleiterscheiben aus einkristallinem Silizium gegen thermisch induzierte Versetzungen, umfassend das Unterziehen einer Halbleiterscheibe einer auf Eigenschaften des Halbleitermaterials abgestimmten Wärmebehandlung in einem Vertikalofen, wobei die Halbleiterscheibe einen Durchmesser aufweist und an Auflagestellen einer Anzahl von Fingern eines Boots aufliegt und ein Abstand der Auflagestellen zu einem Rand der Halbleiterscheibe eine Länge hat, die nicht weniger als 5 % und nicht mehr als 40 % des Durchmessers der Halbleiterscheibe beträgt;
das Durchführen einer BFA-Analyse von einer oder mehreren Teilflächen der Halbleiterscheibe um die Auflagestellen mittels eines SIRD-Systems, wobei der kürzeste Abstand der einen oder mehreren Teilflächen zum Rand der Halbleiterscheibe nicht weniger als 1 mm und nicht mehr als 33 % des Durchmessers der Halbleiterscheibe beträgt.

2. Verfahren nach Anspruch 1, umfassend
eine Auswahl der Wärmebehandlung in Abhängigkeit der Konzentration an interstitiellem Sauerstoff und/oder in Abhängigkeit der elektrischen Resistivität der Halbleiterscheibe.

3. Verfahren nach Anspruch 1 oder Anspruch 2, umfassend
das Durchführen einer der Wärmebehandlung vorausgehenden Wärmebehandlung, wobei die Halbleiterscheibe auf den Fingern des Boots auf weiteren Auflagestellen aufliegt und die Auflagestellen und die weiteren Auflagestellen nicht überlappen.

4. Verfahren nach einem der Ansprüche 1 bis 3, **dadurch gekennzeichnet, dass** die Halbleiterscheibe einen Durchmesser von 300 mm hat und die Länge des Abstands der Auflagestellen zum Rand der Halbleiterscheibe nicht weniger als 45 mm beträgt.

5. Verfahren nach einem der Ansprüche 1 bis 4, **dadurch gekennzeichnet, dass** die Halbleiterscheibe einen Durchmesser von 300 mm hat und der kürzeste Abstand der jeweiligen Teilfläche zum Rand der Halbleiterscheibe nicht weniger als 10 mm beträgt.
